# EUROPEAN PATENT APPLICATION

(11) **EP 4 095 932 A1**
(43) Date of publication of application: **30.11.2022**
(21) Application number: 20840082.0
(22) Date of filing: 27.09.2020
(51) Int. Cl.: H01L 31/05

(54) **MANUFACTURING METHOD FOR SHINGLED ASSEMBLY AND SHINGLED ASSEMBLY**

(30) Priority: 23.01.2020 CN 202010076474
(71) Applicant: Chengdu Yefan Science And Technology Co., Ltd., Sichuan 610041 (CN)
(72) Inventor: DING, Erliang, Hefei, Anhui 230000 (CN); SUN, Jun, Hefei, Anhui 230000 (CN); YIN, Bingwei, Hefei, Anhui 230000 (CN); CHEN, Dengyun, Hefei, Anhui 230000 (CN); LI, Yan, Hefei, Anhui 230000 (CN); SHI, Gang, Hefei, Anhui 230000 (CN); XIE, Yi, Hefei, Anhui 230000 (CN); LIU, Hanyuan, Hefei, Anhui 230000 (CN)
(74) Representative: V.O.
(86) International application number: PCT/CN2020/118132
(87) International publication number: WO 2021/008634

(57) **Abstract**

The present disclosure relates to a method of manufacturing shingled solar module and the shingled solar module. The method includes steps of: arranging solar cells and conductive sheets on a top surface of a bottom package feature along a second direction in a shingled manner into a plurality of solar cell strings, wherein the conductive sheets are disposed at trailing ends of the solar cell strings, and the solar cell strings are arranged along a first direction perpendicular to the second direction to form a cell array; arranging a first busbar and a second busbar on a top or a bottom or the cell array, where the first busbar is in contact with main grid lines of the solar cells at initial ends of the respective solar cell strings, and the second busbar is in electrical contact with the conductive sheets of the respective solar cell strings; and laminating a combined feature comprised of the top package feature, the cell array, and the bottom package feature. In the method according to the present disclosure, the arranging step and the shingling step are combined as one step, in which the cells are shingled and arranged directly on the bottom package feature. In this way, the method is advantageous for operation and can be implemented efficiently at low costs.

## Description

### FIELD

Embodiments of the present disclosure generally relate to the energy field, and more specifically, to a method of manufacturing a shingled solar module and the shingled solar module.

### BACKGROUND

As global fossil fuels, such as coal, oil, natural gas, and the like, are being consumed faster, the ecological environment is deteriorating continually. In particular, the greenhouse gases bring about increasingly serious global climate change, posing a grave threat to the sustainable development of human society. Countries around the world have formulated their own energy development strategies, to cope with the limited conventional fossil fuels and the environmental problems caused by development and consumption. With advantages in reliability, safety, extensiveness, longevity, environmental protection, and adequacy, solar energy has become one of the most important renewable energy resources and will be the main worldwide power supply in the future.

In the new round of energy reform, the photovoltaic industry in China has become a strategic emerging industry with international competitive advantages. However, many problems and challenges are emerging in the development of the photovoltaic industry. For example, the conversion efficiency and reliability are the greatest technical obstacles hindering the development of the photovoltaic industry, and the cost control and the scale form further economic constraints. As a core component of photovoltaic power, there is an irresistible trend to improve conversion efficiency and develope efficient assemblies . The current market is flooded with a variety of efficient assemblies, such as shingles, half pieces, multiple main grids, double-sided assemblies and the like. As the application scenarios and areas of photovoltaic solar module are increased significantly, higher requirements are imposed on its reliability. An efficient, reliable photovoltaic solar module is especially needed in some areas with a high incidence of severe or extreme weather.

In the background of promoting use of the solar energy which is a type of green energy, the shingled solar module reduces remarkably power loss based on the electrical principle of weak-current low-loss (i.e., the proportional relationship between the power loss of the photovoltaic solar module and the square of working current). Secondly, the inter-cell gap areas of the solar cell pack are fully utilized for power generation, and there is a high energy density per unit of area. In addition, an electrically conductive adhesive with elastomeric characteristics is adopted to substitute for a photovoltaic metal welding ribbon in a conventional solar module. The photovoltaic metal welding ribbon in the whole cell sheet has a high series resistance while the electrically conductive adhesive brings about a shorter current loop trip than the former. As a result, the shingled solar module stands out as the most efficient solar module. Moreover, the shingled solar module is more reliable than the conventional photovoltaic module when applied outdoors, because the shingled solar module avoids stress damage of the metal welding ribbon to the cell interconnection locations and other confluence areas. Particularly in a dynamic environment of high and low temperature alternation (as an effect of wind, snow and other nature loads), the conventional solar module with a metal welding ribbon for interconnection and packaging has a much higher failure probability than the shingled solar module in which the cut crystalline silicon cells are interconnected using an elastomeric, electrically-conductive adhesive.

Nowadays, in the mainstream technology of the shingled solar module, an electrically conductive adhesive comprised of a conductive phase and an adhesive phase is used to interconnect the cut cells. Wherein, the conductive phase is mainly formed of precious metal, such as silver particles, or particles of silver-clad copper, silver-clad nickel, silver-clad glass or the like, and plays an electrically conductive role between solar cells, and the shape and distribution of the particles are designed to attain the optimal electrical conduction. In most cases, combinations of flaky or spherical silver powder with a size of D50 < 10µm are preferred at present. The adhesive phase is mainly formed of weather-resistant resin polymer, which is typically selected from acrylic resin, silicone resin, epoxy resin, polyurethane and the like, according to adhesion strength and weathering stability. In order to obtain an electrically conductive adhesive with a low contact resistance, small volume resistivity and high adhesion, and to maintain an excellent long-term weather resistance, manufacturers of electrically conductive adhesives typically formulate the conductive phase and the adhesion phase, thereby ensuring the performance stability of the shingled assemblies in the environmental erosion test at the initial term and the actual long-term outdoor application.

For a solar cell connected via electrically conductive adhesives, after being sealed, there is a problem of relative displacement between electrically conductive adhesives caused by environment erosion (e.g., thermal expansion and contraction resulting from high and low temperature alternation) when used actually outdoors. The most serious problem is current virtual connection or even open circuit caused by a weak connection between the materials after being combined. The weak connection is mainly embodied in the aspect that a process operation window is required in the process of manufacturing an electrically conductive adhesive, and the window is relatively narrow and easily inactivated under the impact of environmental factors, such as temperature and humidity of the workplace, duration of exposure in air after coating the adhesive. There may be veiled threats to the product reliability if the adhesive is applied nonuniformly or even missing somewhere due to the changes in properties of the adhesive during the dispensing, spraying or printing process. In addition, as mainly formed of polymer resin and a large amount of precious metal powder, the electrically conductive adhesive incurs high costs and destroys the ecological environment to a certain extent (e.g., manufacturing and processing of the precious metal pollute the environment). Furthermore, since the electrically conductive adhesive which is paste-like, so somehow flowable in the adhesive-applying or stacking process, overflow probably occurs, thereby causing short circuit between the positive and the negative of the shingled, interconnected solar cell string.

In other words, most of the shingled assemblies manufactured in an adhesion manner via an electrically conductive adhesive have disadvantages of weak interconnection, high requirements on the environment in the manufacturing process, short circuit resulting from overflow, high costs, low production efficiency, and the like.

Besides, the method of manufacturing the shingled solar module includes providing a welding ribbon at two ends of a solar cell string, making arrangement, and then performing busbar welding. In known solution, the steps of first shingling and then making arrangement incurs low efficiency and high costs; separating the shingling step and the arranging step brings about difficulties in changing the arrangement; and a welding ribbon used therein may cause power loss of solar cells and impact the conversion efficiency.

Therefore, there arises a need for providing a method of manufacturing a shingled solar module and the shingled solar module, so as to at least partly solve the above problem.

### SUMMARY

The objective of the present disclosure is to provide a shingled solar module and manufacturing method thereof. In the method according to the present disclosure, the arranging step and the shingling step are combined as one step, in which the cells are shingled and arranged directly on the bottom package feature. In this way, the method is advantageous for operation and can be implemented efficiently at low costs.

On the other hand, in the shingled solar module according to the present disclosure, the busbars have a convergence effect, and the adhesive plays a securing role. It is unnecessary to provide an additional welding ribbon or conductive glue therein. Such arrangement can prevent power loss of the cells and avoid a series of problems probably caused by the conductive glue.

In accordance with one aspect of the present disclosure, there is provided a method of manufacturing a shingled solar module comprising a bottom package feature, a top package feature, and a cell array secured between the bottom package feature and the top package feature. the method comprises steps of:
arranging solar cells and conductive sheets on a top surface of the bottom package feature along a second direction in a shingled manner into a plurality of solar cell strings, wherein the conductive sheets are disposed at trailing ends of the solar cell strings, the respective solar cells are conductively connected to one another via contact of main grid lines, the conductive sheets are in contact with main grid lines of solar cells adjacent thereto, the respective solar cells and the conductive sheets are secured relative to each other via adhesives, and the solar cell strings are arranged along a first direction perpendicular to the second direction to form a cell array;
arranging a first busbar and a second busbar on a top or a bottom or the cell array, wherein the first busbar is in contact with main grid lines of the solar cells at initial ends of the respective solar cell strings, the second busbar is in electrical contact with the conductive sheets of the respective solar cell strings, and each busbar is of a continuous strip structure and the busbars are configured to collect current from the cell array and export the current; and
laminating a combined feature comprising the top package feature, the cell array, and the bottom package feature.

In an embodiment, the method further comprises steps of:
arranging a first conductive adhesive feature on a top surface of the solar cell at an initial end of each of the solar cell strings, the first conductive adhesive feature being in direct contact with a main grid line of the solar cell at the initial end;
arranging a second conductive adhesive feature on a top surface of each of the conductive sheets,
wherein respective conductive adhesive features of the adjacent solar cell strings are spaced apart in the first direction, and
wherein the top package feature comprises a top panel, the first busbar and the second busbar are applied to a bottom surface of the top panel, and the first busbar and the second busbar are aligned with the respective conductive adhesive features in a direction perpendicular to the cell array such that the busbars can simultaneously come into contact with the respective conductive adhesive features of all the solar cell strings.

In an embodiment, the top package feature further comprises a top flexible film disposed between the top panel and the cell array, and the method further comprises: arranging apertures corresponding to the conductive adhesive features on the top flexible film, through which the conductive adhesive features electrically connect to the busbars via apertures.

In an embodiment, the step of applying the first conductive adhesive feature and the second conductive adhesive feature is implemented after arranging the top flexible film on the cell array, and includes: applying a conductive adhesive material on the top flexible film, such that the conductive adhesive material flows through the apertures onto a top surface of the cell array and is solidified as the first conductive adhesive feature and the second conductive adhesive feature.

In an embodiment, the conductive adhesive features are applied through at least one of dispensing, painting, spraying and printing.

In an embodiment, the first busbar and the second busbar are arranged on the cell array, wherein the first busbar is arranged on a top surface of the solar cell at the initial end of the respective solar cell strings and configured to connect, via a conductive adhesive feature or welding, main grid lines of the respective solar cells in contact therewith, and the second busbar is arranged on a top surface of the respective conductive sheets and configured to connect the respective conductive sheets via a conductive adhesive feature or welding.

In an embodiment, the method further comprises a step of applying an adhesive which includes applying the adhesive on each of the solar cells and the conductive sheets, where the adhesive is disposed between each pair of solar cell and conductive sheet adjacent to each other when the solar cells are arranged in the solar cell strings.

In an embodiment, the method further comprises a step of: detecting quality of the adhesive via a camera when applying the adhesive, and removing, based on detection results, solar cells where the adhesive is not applied correctly.

In an embodiment, the step of detecting is performed simultaneously with the step of applying the adhesive, and can provide close-loop feedback to the step of applying the adhesive.

In an embodiment, the method further comprises steps of:
arranging a entire solar cell sheet;
laser grooving the entire solar cell sheet and applying the adhesive; and
splitting the whole solar cell sheet into a plurality of solar cells.

In an embodiment, the method further comprises steps of:
arranging a entire solar cell sheet;
laser grooving the entire solar cell sheet;
splitting the whole solar cell sheet into a plurality of solar cells; and
applying the adhesive on each of the solar cells.

In an embodiment, in a process of shingling the solar cells in solar cell strings, heat and/or pressure applied to overlapping portions between the solar cells to condense the adhesive.

In an embodiment, the bottom package feature comprises a bottom panel and a bottom flexible film disposed between the bottom panel and the cell array, and the method further comprises a step of applying an adhesive on a top surface of the bottom flexible film prior to arranging the solar cells on the bottom package feature.

In an embodiment, the step of applying the adhesive comprises: applying multiple groups of dot-like adhesives on the top surface of the bottom flexible film, where each group of the dot-like adhesives corresponds to one of the solar cell strings and includes one or more rows of dot-like features, and the dot-like adhesives are all arranged sequentially along the second direction and configured to engage bottom surfaces of the respective solar cells in the solar cell string.

In an embodiment, the method further comprises a step of applying an adhesive after arranging the solar cells on the bottom package feature into the solar cell strings, which comprises: applying a strip adhesive on each of the solar cell strings along a second direction, to enable the strip adhesive to traverse the solar cell string.

In an embodiment, the steps of arranging the solar cells into solar cell strings and arranging the solar cell strings into the cell array are implemented by electrostatic absorption or vacuum absorption.

In an embodiment, in a process of arranging the solar cells into the solar cell strings, quality of laminates are detected via a camera, and detection results are fed back to a monitoring platform in real time.

In an embodiment, a manufacturing system further comprises a control device which is associated with the detection mechanism and configured to control a lamination mechanism based on the detection results of the detection mechanism.

In an embodiment, prior to a lamination step, defect detection is performed on pieces to be laminated using EL or PL electroluminescence, and if detection indicates a piece to be laminated is unqualified, defect detection will be performed again after recovery of the piece.

In an embodiment, the method further comprises: a step of arranging the top package feature and a step of arranging the bottom package feature, wherein the step of arranging the bottom package feature comprises:
arranging a bottom panel, and
applying EVA, POE or silica gel to form a flexible film arranged between the rigid panel and the cell array; and
wherein the step of arranging the bottom package feature comprises:
   applying EVA, POE or silica gel to form a flexible film arranged between a top panel and the cell array, and
   arranging the top panel.

In an embodiment, the adhesive is not conductive.

In an embodiment, the method does not comprise a step of arranging a welding ribbon.

In accordance with a further aspect of the present disclosure, there is provided a shingled solar module comprising a bottom package feature, a transparent top package feature, and a cell array disposed between the bottom package feature and the top package feature, the cell array comprising at least two solar cell strings arranged sequentially along a first direction, characterized in that,
each of the solar cell strings comprises a plurality of solar cells and a conductive sheet disposed at trailing ends of the plurality of solar cells, the plurality of solar cells and the conductive sheet being arranged in shingled manner sequentially along a second direction perpendicular to the first direction and secured relative to each other via an adhesive, where the respective solar cells are conductively connected through contact of main grid lines, and the conductive sheet is in contact with the main grid lines of the solar cells adjacent thereto,
wherein the shingled solar module is provided with a first busbar and a second busbar disposed together on a top or bottom side of the cell array, where the first busbar is configured to be in electrically contact with main grid lines of the solar cells at initial ends of the respective solar cell strings, the second busbar is configured to be in electric contact with the conductive sheets of the respective solar cell strings, and each busbar is of a continuous structure and the busbars are configured to collect current from the cell array and export the current.

In an embodiment, a top surface of a solar cell at an initial end of each of the solar cell strings is provided thereon with a first conductive adhesive feature in direct contact with a main grid line of the same solar cell, a top surface of the conductive sheet is provided thereon with a second conductive feature, respective conductive adhesive features of the solar cell strings adjacent to each other are spaced apart in the first direction, the top package feature comprises a top panel, and the busbars are formed on a bottom surface of the top panel and aligned with the respective conductive adhesive features in a direction perpendicular to the cell array, enabling the busbars to come into contact with the corresponding conductive adhesive features of the solar cell strings at the same time.

In an embodiment, the top package feature further comprises a top flexible film disposed between the top panel and the cell array, and the top flexible film is provided thereon with apertures corresponding to the conductive adhesive features, conductive adhesive features electrically connect to the busbars via apertures.

In an embodiment, each section of the conductive adhesive feature is of a dot-like structure, or a strip structure extending along the first direction.

In an embodiment, the busbars are formed on the cell array, where the first busbar connects the main grid lines at the initial ends of the respective solar cell strings, and the second busbar connects the conductive sheets of the respective solar cell strings.

In an embodiment, the top package feature is not conductive.

In an embodiment, the adhesive is disposed between each pair of adjacent solar cells in each of the solar cell strings.

In an embodiment, the adhesive is arranged between each of the solar cells and the bottom package feature such that all of the solar cells are secured relative to the bottom package feature.

In an embodiment, the bottom package feature comprises a bottom panel and a bottom flexible film disposed between the bottom panel and the cell array, and the adhesive is applied onto a top surface of the bottom flexible film.

In an embodiment, the adhesive includes multiple groups of dot-like adhesives pre-arranged on the top surface of the bottom flexible film, each group of the dot-like adhesives corresponds to one of the solar cell strings, each group of the dot-like adhesives comprises one or more rows of dot-like adhesives, and the dot-like adhesives are all arranged sequentially along the second direction and configured to engage a bottom surface of each of the solar cells in the solar cell string.

In an embodiment, each of the solar cell strings is provided thereon with the adhesive of a strip structure extending along the second direction and traversing the solar cell string.

In an embodiment, the bottom package feature comprises a bottom panel and a flexible film disposed between the bottom panel and the cell array, the flexible film is of an EVA film structure, POE film structure or silica gel film structure, and the top package feature comprises a top panel and a flexible film disposed between the top panel and the cell array, the flexible film is of an EVA film structure, POE film structure or silica gel film structure.

In an embodiment, the adhesive is not conductive.

In an embodiment, the shingled solar module does not comprise a welding ribbon.

In the method according to the present disclosure, the arranging step and the shingling step are combined as one step, in which the cells are shingled and arranged directly on the bottom package feature. In this way, the method is advantageous for operation and can be implemented efficiently at low costs. On the other hand, in the shingled solar module according to the present disclosure, the busbars have a convergence effect, and the adhesive plays a securing role. It is unnecessary to provide an additional welding ribbon or conductive glue therein. Such arrangement can prevent power loss of the cells and avoid a series of problems probably caused by the conductive glue.

### BRIEF DESCRIPTION OF THE DRAWINGS

In order to better understand the above and other objectives, features and advantages of the present disclosure, preferred embodiments as shown in the accompanied drawings are provided. Throughout the drawings, the same or similar reference symbols refer to the same or similar elements. It would be appreciated by those skilled in the art that the drawings are provided to illustrate the preferred embodiments of the present disclosure, without suggesting any limitation to the scope of the present disclosure, and respective components therein are not drawn to scale.
Fig. 1 is a explosive view of a shingled solar module in a process according to a first embodiment of the present disclosure;
Fig. 2A is a sectional view that the shingled solar module in Fig 1 cut along an A-A line, and Fig. 2B is a sectional view that the shingled solar module in Fig. 1 cut along a B-B line;
Fig. 3 is a explosive view of a shingled solar module in a process according to a second embodiment of the present disclosure;
Fig. 4 is a explosive view of a shingled solar module in a process according to a third embodiment of the present disclosure; and
Fig. 5 is a explosive view of a shingled solar module in a process according to a fourth embodiment of the present disclosure.

### DETAILED DESCRIPTION OF EMBODIMENTS

Reference will now be made to the drawings to describe in detail the embodiments of the present disclosure. The description here is only about preferred embodiments of the present disclosure, and those skilled in the art would envision, on the basis of the preferred embodiments described herein, other manners that can implement the present disclosure, which also fall into the scope of the present disclosure.

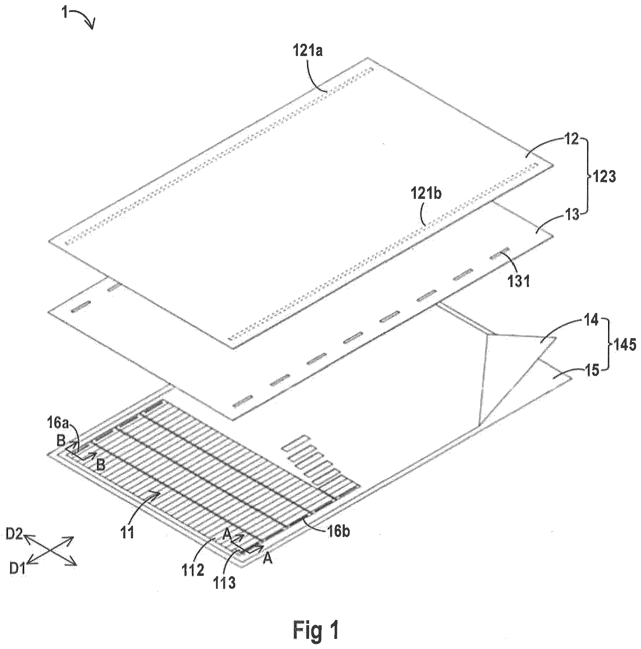

The present disclosure provides a shingled solar module and manufacturing method thereof. Figs. 1-5 illustrate some preferred embodiments of the present disclosure. Reference will now be made to the drawings to describe respective embodiments.

### First embodiment

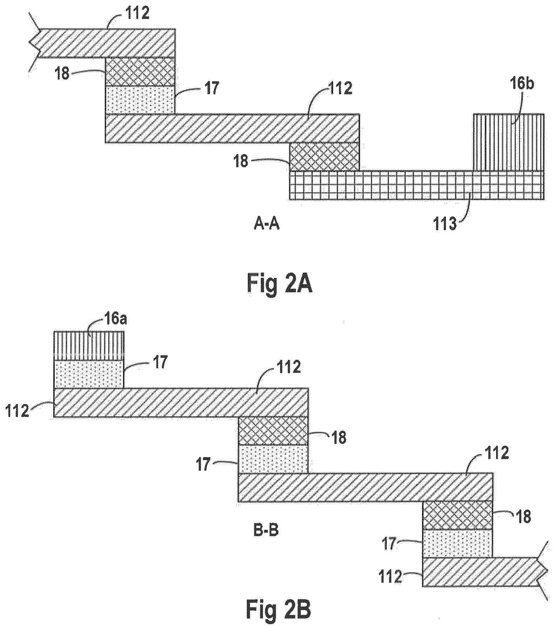

Figs. 1, 2A and 2B illustrate a shingled solar module 1 according to a first embodiment of the present disclosure. It would be appreciated that, since the shingled solar module 1 as shown in Fig. 1 is in the progress of manufacturing, the respective components are separated, which should form an integral package feature after the manufacturing is completed. As shown in Fig. 1, the shingled solar module 1 includes a bottom package feature 145, a transparent top package feature 123, and a cell array 11 that can be secured between the bottom package feature 145 and the top package feature 123.

Wherein, the cell array 11 may generally be read as an array of solar cells 112, the solar cells 112 are arranged to form solar cell strings in a shingled manner, and a plurality of the solar cell strings in turn are arranged to form a cell array 11. A top conductive feature includes a top panel 12 and a top flexible film 13 disposed between the top panel 12 and the cell array 11 while a bottom conductive feature includes a bottom panel 15 and a bottom flexible film 14 disposed between the bottom panel 15 and the cell array 11. The top panel 12 and the bottom panel 15, for example, may be rigid panels, such as tempered glass. The top panel 12 may also be a polymer back plate. The top flexible film 13 and the bottom flexible film 14 may have a flexible film structure formed of EVA, POE or silica gel, respectively.

Specifically, each solar cell string includes a plurality of solar cells 12 arranged in a shingled manner in a second direction D2, and a conductive sheet 113 disposed at trailing ends of the plurality of solar cells 112. The solar cell 112 is provided at the top surface with a front electrode 17 and at the bottom surface with a back electrode 18. The conductive sheet 113 is formed of a conductive material.

For example, if the respective solar cells 112 in the solar cell string are arranged in the manner as shown in Figs. 2A and 2B (i.e., for every two adjacent solar cells 112, the back electrode 18 of the preceding solar cell 112 is in contact with the front electrode 17 of the following), the front electrode 17 of the solar cell 112 at the initial end of the solar cell string is exposed, and the back electrode 18 of the last solar cell 112 of the solar cell string is also exposed. In order to form a loop, busbars are required to be simultaneously in contact with the exposed front electrode 17 and back electrode 18 of the solar cell string. Providing the conductive sheet 113 at the trailing end of the solar cell string enables busbars 121 disposed on the top surface of the solar cell string to be in contact with the back electrode 18. Specifically, the conductive sheets 113 can be configured in a structure similar to that of the common solar cell 112 and arranged at the trailing end of the solar cell string in a shingled manner, such that the conductive sheet 113 can be in contact with the back electrode 18 of the last solar cell 112 of the solar cell string. If conductively contacting with the top surface of the conductive sheet 113, the busbars 121 are actually in conductive contact with the back electrode 18 of the last solar cell 112. In this embodiment, conductive connection between the conductive sheet 113 and the busbar 121 is achieved via a conductive adhesive feature 16.

Referring back to Fig. 1, a first conductive adhesive feature 16a is disposed on the top surface of the solar cell 112 at the initial end of the solar cell string and configured in direct contact with the front electrode 17 of the same solar cell 12, and a second conductive adhesive feature 16b is disposed on the top surface of the conductive sheet 113. A corresponding conductive adhesive feature of an adjacent solar cell string is spaced apart in a first direction D1. Each section of the first conductive adhesive feature 16a and the second conductive adhesive feature 16b may be of a dot-like structure, or a strip structure extending in the first direction D1. In the embodiment, respective solar cells 112 are conductively connected to one another via direct contact of main grid lines. However, in other embodiments not shown, the solar cells 112 can be in conductive contact via conductive glue.

The busbars are formed on the bottom surface of the top panel 12, and their positions are schematically shown with dotted lines on the top panel 12. The busbars include a first busbar 121a and a second busbar 121b, where the first busbar 121a is aligned with the first conductive adhesive feature 16a in a direction perpendicular to the cell array 11, and the second busbar 121b is aligned with the second conductive adhesive feature 16b in the direction perpendicular to the cell array 11, such that the busbar can be in contact with the conductive adhesive features corresponding to all the solar cell strings simultaneously.

In addition, the top flexible film 13 is provided thereon with apertures 131 corresponding to the first conductive adhesive feature 16a and the second conductive adhesive feature 16b, through which the conductive adhesive structure can pass to come into contact with the busbars.

In this embodiment, the respective solar cells 112 are secured relative to one another via an adhesive among the respective solar cells 112. For example, the adhesive may be applied to each solar cell 112 to adhere it to a further solar cell 112 when the two are shingled. Alternatively, each solar cell string may be provided with a transparent adhesive which may be of a strip structure extending along the second direction and traversing the solar cell string. Preferably, the adhesive may only acts for adhering, which is not conductive.

As can be seen from the above, since the adhesive can secure the respective solar cells 112 relative to one another and the top package feature 123, the bottom package feature 145 and the solar cells 112 can be secured as one piece after lamination, the shingled solar module 1 according to the embodiment may not be provided with a welding ribbon.

According to the present embodiment, there is further provided a method of manufacturing the shingled solar module 1 as shown in Fig. 1, which includes an arranging and shingling step, busbar arrangement step, and lamination step.

In the arranging and shingling step, on the top surface of the bottom flexible film 14, the solar cells 112 and the conductive sheets 113 are arranged as a plurality of solar cell strings in a shingled manner in the second direction D2. In the circumstance, the conductive sheets 113 are disposed at the trailing ends of the respective solar cell strings, the respective solar cells 112 are electrically connected via direct contact of main grid lines, the conductive sheets 113 are in direct contact with the main grid lines of the solar cells 112 adjacent thereto, the respective solar cell strings are arranged along the first direction D1 perpendicular to the second direction D2 to form a cell array 11, and the respective solar cells 112 and the conductive sheets 113 are secured relative to each other via an adhesive. The shingling process may be implemented by electrostatically absorbing or vacuum-absorbing the solar cells 112 onto the bottom flexible film 14.

As mentioned above, in this step, the arranging step and the shingling step are combined as one, where shingling is performed directly on the bottom package feature, the respective cells are secured relative to one another, and arrangement is implemented when shingling is being performed. Such step is advantageous for operation and can be implemented efficiently at low costs.

Wherein, the step of applying the adhesive may include: applying the adhesive on each solar cell 112 and the conductive sheet 113, to ensure that the adhesive is present between each pair of the adjacent solar cell 112 and the conductive sheet 113 when the solar cells 112 are arranged in a solar cell string. Furthermore, when the adhesive is being applied, quality of the adhesive is detected via a camera, and the solar cells 12 where the adhesive is not correctly applied are removed based on the detection results. More preferably, the detection step is performed when the adhesive is applied, and the detection step can provide close-loop feedback to the step of applying the adhesive.

The busbar arrangement step includes: arranging a first busbar 121a and a second busbar 121b on the top of the cell array 11, or arranging a first busbar 121a and a second busbar 121b at the bottom of the cell array 11, such that the first busbar 121 is in electrical contact with the main grid line of the solar cell 112 at the initial end of the respective solar cell string, and the second busbar 121b is in electrical contact with the conductive sheets 113 of the respective solar cell strings. Both of the busbars are of a continuous strip structure and configured to collect current from the cell array 11 and export the same.

Specifically, in the shingled solar module 1 as shown in Fig. 1, the busbars in the embodiment are disposed on the bottom surface of the top panel 12. The method according to the present application further includes a step of arranging conductive adhesive features. The step of arranging conductive adhesive features includes: arranging a first conductive adhesive feature 16a on the top surface of the solar cell 112 at the initial end of each solar cell string, to make the first conductive adhesive feature 16a in direct contact with the main grid lines (which is the front electrode 17 in this embodiment) of the solar cell 12 at the initial end; and arranging a second conductive adhesive feature 16b on the top surface of each conductive sheet 113, where the conductive adhesive features corresponding to the adjacent solar cell strings are spaced apart in the first direction D1.

In addition, the top package feature 123 includes a top panel 12 and a top flexible film 13; two busbars 121 are respectively disposed at two sides of the bottom surface of the top panel 12 and aligned with the respective conductive adhesive features in a direction perpendicular to the cell array 11, enabling simultaneous contact with the respective conductive adhesive features of all the solar cell strings.

Moreover, the method further includes: arranging apertures 131 corresponding to the conductive adhesive features on the top flexible film 13, through which the conductive adhesive features electrically connect to the busbars via apertures.

Preferably, the step of applying the first conductive adhesive feature 16a and the second conductive adhesive 16b is implemented after arranging the top flexible film 13 on the cell array 11 and includes: applying a conductive adhesive material at two sides of the top flexible film, such that the conductive adhesive material flows through the apertures 131 to the top surface of the cell array 11 and is condensed there as the first conductive adhesive feature 16a and the second conductive adhesive feature 16b. Furthermore, the conductive adhesive features may be applied from process of dispensing, painting, spraying or printing.

Typically, small pieces of the solar cell 112 are split from an entire sheet of solar cell, and the step of applying the adhesive may be arranged before or after splitting. For example, the entire sheet of solar cell may be laser grooved, applied with an adhesive, and then split into a plurality of solar cells 112. Alternatively, the entire sheet of the solar cell may be laser grooved and then split into a plurality of solar cells 112, and the adhesive is subsequently applied to each solar cell 112.

Preferably, the step of shingling solar cells 112 and the step of applying the adhesive may be implemented simultaneously. For example, when the solar cells 112 are shingled to form solar cell strings, heat and/or pressure applied to the overlapping portions between the solar cells 112. Alternatively, the adhesive here is cured through air drying, ultraviolet rays solidifying.

Also preferably, in the process of arranging the solar cells 112 into solar cell strings, the quality of the shingled cells is detected via a detection device such as a camera, and the detection results are fed back to a monitoring platform in real time. More preferably, the manufacturing system further includes a control device which is associated with a mechanism for detection and configured for close-loop controlling the mechanism for detection.

The last step of the manufacturing process is a lamination step. In the lamination step, the top package feature 123, the cell array 11 and the bottom package feature 145 are laminated together. Prior to the lamination step, defect detection is performed on pieces to be laminated using EL electroluminescence or PL electroluminescence. If the detection indicates a piece is unqualified, defect detection is performed again after recovery of the piece to be laminated.

Since the aforesaid steps achieve the effect that the shingled solar module 1 is packaged and secured, and the solar cells 112 are conductively connected and can export the current, a step of applying a welding ribbon is not necessary any longer.

### Second embodiment

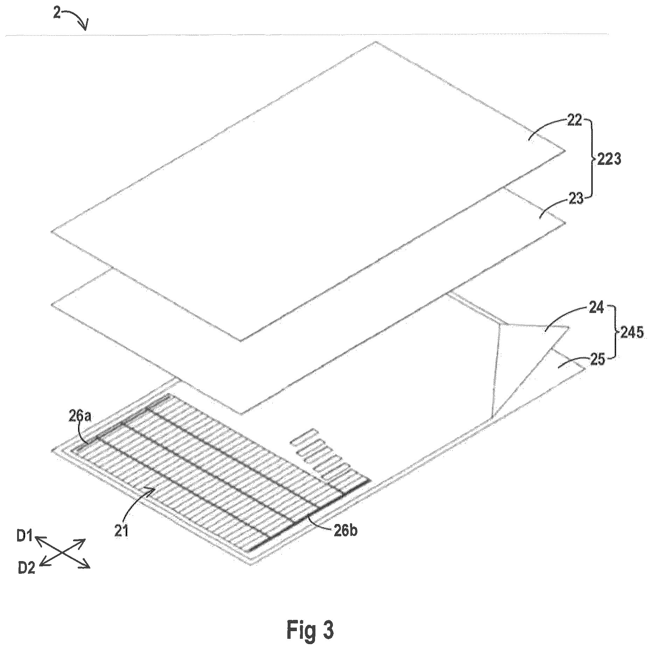

Fig. 3 illustrates a shingled solar module 2 according to a second embodiment of the present disclosure, in which the parts identical or similar to those in the first embodiment will be omitted or described briefly.

The shingled solar module 2 includes a cell array 21, a top package feature 223 having a top panel 22 and a top flexible film 23, and a bottom package feature 245 having a bottom panel 25 and a bottom flexible film 24.

In this embodiment, busbars are both disposed on the cell array 21. Wherein, a first busbar 26a is disposed on the top surface of the solar cell at the initial end of all the solar cell strings and configured to connect, via a conductive adhesive feature or welding, all the front electrodes of the respective solar cells in contact therewith; and a second busbar 26b is disposed on the top surfaces of the respective conductive sheets and configured to connect the respective conductive sheets via a conductive adhesive feature or welding.

The top panel 22 may be formed of a non-conductive transparent or opaque material, and it is unnecessary to provide a conductive mechanism, like a busbar, on the top panel 22.

### Third embodiment

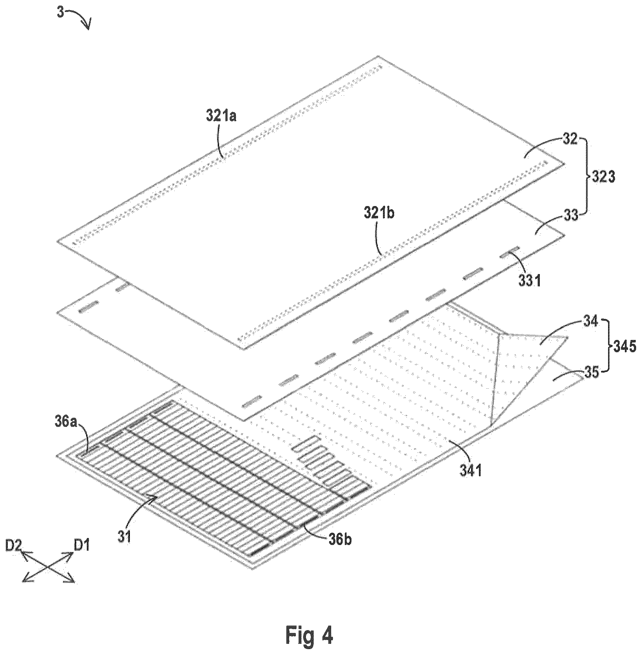

Fig. 4 illustrates a shingled solar module 3 according to a third embodiment of the present disclosure, in which the parts identical or similar to those in the first embodiment will be omitted or described briefly.

The shingled solar module 3 includes a top package feature 323, a bottom package feature, and a cell array 31. The top package feature 323 includes a top panel 32 and a top flexible film 33 while the bottom package feature includes a bottom panel 35 and a bottom flexible film 34. The top panel 32 at the lower surface is provided with a first busbar 321a and a second busbar 321b; the top flexible film 33 is provided thereon with apertures 331 through which a first conductive adhesive feature 36a and a second conductive adhesive feature 36b on the cell array 31 can pass to come into electrical contact with the respective busbars.

In the present embodiment, an adhesive 341 is applied onto the top surface of the bottom flexible film 34. When shingled on the upper surface of the bottom flexible film 34, the respective solar cells can be secured relative to the bottom flexible film 34 via the adhesive 341 and thus secured relative to one another.

Preferably, as shown in Fig. 4, the adhesive 341 includes multiple groups of dot-like adhesives 341 pre-arranged on the top surface of the bottom flexible film 34, where each group of dot-like adhesives 341 corresponds to a solar cell string, each group of dot-like adhesives 341 includes one or more rows, and such adhesives 341 are all arranged along a second direction and each configured to engage the bottom surface of every solar cell in the solar cell string.

Accordingly, the method of manufacturing the shingled solar module includes a step of applying the adhesives 341 onto the top surface of the bottom flexible film 34 prior to arranging the solar cells on the bottom package feature. The step of applying the adhesives 341 includes: applying multiple groups of dot-like adhesives 341 on the top surface of the bottom flexible film 34, where each group of dot-like adhesives 341 corresponds to a solar cell string and includes one or more rows of dot-like features, and the dot-like adhesives 341 are all arranged sequentially along the second direction and each configured to engage the bottom surface of the respective solar cell.

### Fourth embodiment

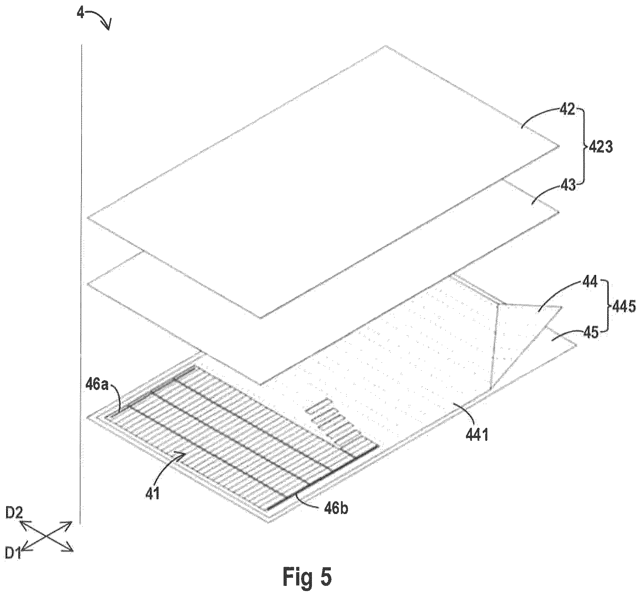

Fig. 5 illustrates a shingled solar module according to a fourth embodiment of the present disclosure, in which the parts identical or similar to those in the first embodiment will be omitted or described briefly.

The shingled solar module 4 includes a cell array 41, a top package feature 423 having a top panel 42 and a top flexible film 43, and a bottom package feature 445 having a bottom panel 45 and a bottom flexible film 44.

In the embodiment, a first busbar 46a and a second busbar 46b are both disposed on the cell array 41. Wherein, the first busbar 46a is disposed on the top surface of the solar cell at the initial end of all the solar cell strings and configured to connect, via a conductive adhesive feature or welding, all the front electrodes of the respective solar cells in contact therewith; and the second busbar 46b is disposed on the top surfaces of the respective conductive sheets and configured to connect the respective conductive sheets via a conductive adhesive feature or welding.

The top panel 42 may be formed of a non-conductive transparent or opaque material, and it is unnecessary to provide a conductive mechanism, like a busbar, on the top panel 42.

In the present embodiment, an adhesive 441 is applied onto the top surface of the bottom flexible film 44. When shingled on the upper surface of the bottom flexible film 44, the respective solar cells can be secured relative to the bottom flexible film 44 via the adhesive 441 and thus secured relative to one another.

Preferably, as shown in Fig. 4, the adhesive 441 includes multiple groups of dot-like adhesives 441 pre-arranged on the top surface of the bottom flexible film 44, where each group of dot-like adhesives 441 corresponds to a solar cell string, each group of dot-like adhesives 441 includes one or more rows, and the adhesives 441 are all arranged along a second direction and each configured to engage the bottom surface of the respective solar cell in the solar cell string.

The aforementioned embodiments are examples of the method and the structure according to the present disclosure. In the method according to the present disclosure, the arranging step and the shingling step are combined as one step, in which the cells are directly shingled and arranged on the bottom package feature. In this way, the method is advantageous for operation and can be implemented efficiently at low costs. Furthermore, in the shingled solar module according to the present disclosure, the busbars have a convergence effect, and the adhesive plays a securing role. It is unnecessary to additionally provide a welding ribbon or conductive glue therein. Such arrangement can prevent power loss of the cells and avoid a series of problems probably caused by the conductive glue.

The foregoing description on the various embodiments of the present disclosure has been presented to those skilled in the relevant fields for purposes of illustration, but are not intended to be exhaustive or limited to a single embodiment disclosed herein. As aforementioned, many substitutions and variations will be apparent to those skilled in the art. Therefore, although some alternative embodiments have been described above, those skilled in the art can envision or develop other embodiments more easily. The present disclosure is intended to cover all substitutions, modifications and variations of the present disclosure as described herein, as well as other embodiments falling into the spirits and scope of the present disclosure.

### Reference sign

shingled solar module 1, 2, 3, 4
cell array 11, 21, 31, 41
top package feature 123, 223, 323, 423
bottom package feature 145, 245, 345, 445
top panel 12, 22, 32, 42
top flexible film 13, 23, 33, 43
bottom panel 15, 25, 34, 45
bottom flexible film 14, 24, 34, 44
first busbar 121a, 26a, 321a, 46a
second busbar 121b, 26b, 321b, 46b
first conductive adhesive feature 16a, 36
second conductive adhesive feature 16b, 36b
aperture 131, 331
adhesive 341, 441
solar cell 112
conductive sheet 113
front electrode 17
back electrode 18
first direction D1
second direction D2

## Claims

1. A method of manufacturing a shingled solar module comprising a bottom package feature, a top package feature, and a cell array secured between the bottom package feature and the top package feature, **characterized in that** the method comprises steps of:
arranging solar cells and conductive sheets on a top surface of the bottom package feature along a second direction in a shingled manner into a plurality of solar cell strings, wherein the conductive sheets are disposed at trailing ends of the solar cell strings, the respective solar cells are conductively connected to one another via contact of main grid lines, the conductive sheets are in contact with main grid lines of solar cells adjacent thereto, the respective solar cells and the conductive sheets are secured relative to each other via adhesives, and the solar cell strings are arranged along a first direction perpendicular to the second direction to form a cell array;
arranging a first busbar and a second busbar on a top side or a bottom side of the cell array, wherein the first busbar is in contact with main grid lines of the solar cells at initial ends of the respective solar cell strings, the second busbar is in electrical contact with the conductive sheets of the respective solar cell strings, and each busbar is of a continuous strip structure and the busbars are configured to collect current from the cell array and export the current; and
laminating a combined feature comprising the top package feature, the cell array, and the bottom package feature.

2. The method according to claim 1, **characterized by** further comprising:
arranging a first conductive adhesive feature on a top surface of the solar cell at an initial end of each of the solar cell strings, the first conductive adhesive feature being in direct contact with a main grid line of the solar cell at the initial end;
arranging a second conductive adhesive feature on a top surface of each of the conductive sheets,
wherein respective conductive adhesive features of the adjacent solar cell strings are spaced apart in the first direction, and
wherein the top package feature comprises a top panel, the first busbar and the second busbar are applied to a bottom surface of the top panel, and the first busbar and the second busbar are aligned with the respective conductive adhesive features in a direction perpendicular to the cell array such that the busbars can simultaneously come into contact with the respective conductive adhesive features of all the solar cell strings.

3. The method according to claim 2, **characterized in that** the top package feature further comprises a top flexible film disposed between the top panel and the cell array, and the method further comprises: arranging apertures corresponding to the conductive adhesive features on the top flexible film, conductive adhesive features electrically connect to the busbars via apertures.

4. The method according to claim 3, **characterized in that** the step of applying the first conductive adhesive feature and the second conductive adhesive feature is implemented after arranging the top flexible film on the cell array, and includes: applying a conductive adhesive material on the top conductive film, such that the conductive adhesive material flows through the apertures onto a top surface of the cell array and is solidified as the first conductive adhesive feature and the second conductive adhesive feature.

5. The method according to claim 2, **characterized in that** the conductive adhesive features are applied through at least one of dispensing, painting, spraying and printing.

6. The method according to claim 1, **characterized in that** the first busbar and the second busbar are arranged on the cell array, wherein the first busbar is arranged on a top surface of the solar cell at the initial end of the respective solar cell strings and configured to connect, via a conductive adhesive feature or welding, main grid lines of the respective solar cells in contact therewith, and the second busbar is arranged on a top surface of the respective conductive sheets and configured to connect the respective conductive sheets via a conductive adhesive feature or welding.

7. The method according to claim 1, **characterized by** further comprising a step of applying an adhesive which includes applying the adhesive on each of the solar cells and the conductive sheets, where the adhesive is disposed between each pair of solar cell and conductive sheet adjacent to each other when the solar cells are arranged in the solar cell strings.

8. The method according to claim 7, **characterized by** further comprising a step of:
detecting quality of the adhesive via a camera when applying the adhesive, and removing,
based on detection results, solar cells where the adhesive is not applied correctly.

9. The method according to claim 8, **characterized in that** the step of detecting is performed simultaneously with the step of applying the adhesive, and can provide close-loop feedback to the step of applying the adhesive.

10. The method according to claim 7, **characterized by** further comprising steps of:
arranging a entire solar cell sheet;
laser grooving the entire solar cell sheet and applying the adhesive; and
splitting the whole solar cell sheet into a plurality of solar cells.

11. The method according to claim 7, **characterized by** further comprising:
arranging a entire solar cell sheet;
laser grooving the entire solar cell sheet;
splitting the whole solar cell sheet into a plurality of solar cells; and
applying the adhesive on each of the solar cells.

12. The method according to claim 7, **characterized in that**, in a process of shingling the solar cells in solar cell strings, heat and/or pressure applied to overlapping portions between the solar cells to condense the adhesive.

13. The method according to claim 1, **characterized in that** the bottom package feature comprises a bottom panel and a bottom flexible film disposed between the bottom panel and the cell array, and the method further comprises a step of applying an adhesive on a top surface of the bottom flexible film prior to arranging the solar cells on the bottom package feature.

14. The method according to claim 13, **characterized in that** the step of applying the adhesive comprises: applying multiple groups of dot-like adhesives on the top surface of the bottom flexible film, where each group of the dot-like adhesives corresponds to one of the solar cell strings and includes one or more rows of dot-like features, and the dot-like adhesives are all arranged sequentially along the second direction and configured to engage bottom surfaces of the respective solar cells in the solar cell string.

15. The method according to claim 1, **characterized by** comprising a step of applying an adhesive after arranging the solar cells on the bottom package feature into the solar cell strings, which comprises: applying a strip adhesive on each of the solar cell strings along a second direction, to enable the strip adhesive to traverse the solar cell string.

16. The method according to claim 1, **characterized in that** the steps of arranging the solar cells into solar cell strings and arranging the solar cell strings into the cell array are implemented by electrostatic absorption or vacuum absorption.

17. The method according to claim 1, **characterized in that**, in a process of arranging the solar cells into the solar cell strings, quality of laminates are detected via a camera, and detection results are fed back to a monitoring platform in time.

18. The method according to claim 17, **characterized in that** a manufacturing system further comprises a control device which is associated with the detection mechanism and configured to control a lamination mechanism based on the detection results of the detection mechanism.

19. The method according to claim 1, **characterized in that**, prior to a lamination step, defect detection is performed on pieces to be laminated using EL or PL electroluminescence, and if detection indicates a piece to be laminated is unqualified, defect detection will be performed again after recovery of the piece.

20. The method of claim 1, **characterized by** further comprising a step of arranging the top package feature and a step of arranging the bottom package feature, wherein the step of arranging the bottom package feature comprises:
arranging a bottom panel, and
applying EVA, POE or silica gel to form a flexible film arranged between the rigid panel and the cell array; and
wherein the step of arranging the bottom package feature comprises:
applying EVA, POE or silica gel to form a flexible film arranged between the top panel and the cell array, and
arranging a top panel.

21. The method according to any of claims 1-20, **characterized in that** the adhesive is not conductive.

22. The method according to any of claims 1-20, **characterized by** not comprising a step of arranging a welding ribbon.

23. A shingled solar module, comprising a bottom package feature, a transparent top package feature, and a cell array disposed between the bottom package feature and the top package feature, the cell array comprising at least two solar cell strings arranged sequentially along a first direction, **characterized in that**,
each of the solar cell strings comprises a plurality of solar cells and a conductive sheet disposed at trailing ends of the plurality of solar cells, the plurality of solar cells and the conductive sheet being arranged in shingled manner sequentially along a second direction perpendicular to the first direction and secured relative to each other via an adhesive, wherein the respective solar cells are conductively connected through contact of main grid lines, and the conductive sheet is in contact with the main grid lines of the solar cells adjacent thereto,
wherein the shingled solar module is provided with a first busbar and a second busbar disposed together on a top or bottom side of the cell array, where the first busbar is configured to be in electrically contact with main grid lines of the solar cells at initial ends of the respective solar cell strings, the second busbar is configured to be in electric contact with the conductive sheets of the respective solar cell strings, and the each busbar is of a continuous structure and the busbars are configured to collect current from the cell array and export the current.

24. The shingled solar module according to claim 23, **characterized in that** a top surface of a solar cell at an initial end of each of the solar cell strings is provided thereon with a first conductive adhesive feature in direct contact with a main grid line of the same solar cell, a top surface of the conductive sheet is provided thereon with a second conductive feature, respective conductive adhesive features of the solar cell strings adjacent to each other are spaced apart in the first direction, the top package feature comprises a top panel, and the busbars are formed on a bottom surface of the top panel and aligned with the respective conductive adhesive features in a direction perpendicular to the cell array, enabling the busbars to come into contact with the corresponding conductive adhesive features of the solar cell strings at the same time.

25. The shingled solar module according to claim 24, **characterized in that** the top package feature further comprises a top flexible film disposed between the top panel and the cell array, and the top flexible film is provided thereon with apertures corresponding to the conductive adhesive features, conductive adhesive features electrically connect to the busbars via apertures.

26. The shingled solar module according to claim 24, **characterized in that** each section of the conductive adhesive feature is of a dot-like structure, or a strip structure extending along the first direction.

27. The shingled solar module according to claim 23, **characterized in that** the busbars are formed on the cell array, where the first busbar connects the main grid lines at the initial ends of the respective solar cell strings, and the second busbar connects the conductive sheets of the respective solar cell strings.

28. The shingled solar module according to claim 27, **characterized in that** the top package feature is not conductive.

29. The shingled solar module according to claim 23, **characterized in that** the adhesive is disposed between each pair of adjacent solar cells in each of the solar cell strings.

30. The shingled solar module according to claim 23, **characterized in that** the adhesive is arranged between each of the solar cells and the bottom package feature such that all of the solar cells are secured relative to the bottom package feature.

31. The shingled solar module according to claim 30, **characterized in that** the bottom package feature comprises a bottom panel and a bottom flexible film disposed between the bottom panel and the cell array, and the adhesive is applied onto a top surface of the bottom flexible film.

32. The shingled solar module according to claim 31, **characterized in that** the adhesive includes multiple groups of dot-like adhesives pre-arranged on the top surface of the bottom flexible film, each group of the dot-like adhesives corresponds to one of the solar cell strings, each group of the dot-like adhesives comprises one or more rows of dot-like adhesives, and the dot-like adhesives are all arranged sequentially along the second direction and configured to engage a bottom surface of each of the solar cells in the solar cell string.

33. The shingled solar module according to claim 23, **characterized in that** each of the solar cell strings is provided thereon with the adhesive of a strip structure extending along the second direction and traversing the solar cell string.

34. The shingled solar module according to claim 23, **characterized in that** the bottom package feature comprises a bottom panel and a flexible film disposed between the bottom panel and the cell array, the flexible film is of an EVA film structure, POE film structure or silica gel film structure, and the top package feature comprises a top panel and a flexible film disposed between the top panel and the cell array, the flexible film is of an EVA film structure, POE film structure or silica gel film structure.

35. The shingled solar module according to any of claims 23-34, **characterized in that** the adhesive is not conductive.

36. The shingled solar module according to any of claims 23-34, **characterized by** not comprising a welding ribbon.

## Amended claims

### Amended claims under Art. 19.1 PCT

1. A method of manufacturing a shingled solar module comprising a bottom package feature, a top package feature, and a cell array secured between the bottom package feature and the top package feature, **characterized in that** the method comprises steps of:
arranging solar cells and conductive sheets on a top surface of the bottom package feature along a second direction in a shingled manner into a plurality of solar cell strings, wherein the conductive sheets are disposed at trailing ends of the solar cell strings, the respective solar cells are conductively connected to one another via contact of main grid lines, the conductive sheets are in contact with main grid lines of solar cells adjacent thereto, the respective solar cells and the conductive sheets are secured relative to each other via adhesives, and the solar cell strings are arranged along a first direction perpendicular to the second direction to form a cell array;
arranging a first busbar and a second busbar on a top side or a bottom side of the cell array, wherein the first busbar is in contact with main grid lines of the solar cells at initial ends of the respective solar cell strings, the second busbar is in electrical contact with the conductive sheets of the respective solar cell strings, and each busbar is of a continuous strip structure and the busbars are configured to collect current from the cell array and export the current; and
laminating a combined feature comprising the top package feature, the cell array, and the bottom package feature.

2. The method according to claim 1, **characterized by** further comprising:
arranging a first conductive adhesive feature on a top surface of the solar cell at an initial end of each of the solar cell strings, the first conductive adhesive feature being in direct contact with a main grid line of the solar cell at the initial end;
arranging a second conductive adhesive feature on a top surface of each of the conductive sheets,
wherein respective conductive adhesive features of the adjacent solar cell strings are spaced apart in the first direction, and
wherein the top package feature comprises a top panel, the first busbar and the second busbar are applied to a bottom surface of the top panel, and the first busbar and the second busbar are aligned with the respective conductive adhesive features in a direction perpendicular to the cell array such that the busbars can simultaneously come into contact with the respective conductive adhesive features of all the solar cell strings.

3. The method according to claim 2, **characterized in that** the top package feature further comprises a top flexible film disposed between the top panel and the cell array, and the method further comprises: arranging apertures corresponding to the conductive adhesive features on the top flexible film, conductive adhesive features electrically connect to the busbars via apertures.

4. The method according to claim 3, **characterized in that** the step of applying the first conductive adhesive feature and the second conductive adhesive feature is implemented after arranging the top flexible film on the cell array, and includes: applying a conductive adhesive material on the top flexible film, such that the conductive adhesive material flows through the apertures onto a top surface of the cell array and is solidified as the first conductive adhesive feature and the second conductive adhesive feature.

5. The method according to claim 2, **characterized in that** the conductive adhesive features are applied through at least one of dispensing, painting, spraying and printing.

6. The method according to claim 1, **characterized in that** the first busbar and the second busbar are arranged on the cell array, wherein the first busbar is arranged on a top surface of the solar cell at the initial end of the respective solar cell strings and configured to connect, via a conductive adhesive feature or welding, main grid lines of the respective solar cells in contact therewith, and the second busbar is arranged on a top surface of the respective conductive sheets and configured to connect the respective conductive sheets via a conductive adhesive feature or welding.

7. The method according to claim 1, **characterized by** further comprising a step of applying an adhesive which includes applying the adhesive on each of the solar cells and the conductive sheets, where the adhesive is disposed between each pair of solar cell and conductive sheet adjacent to each other when the solar cells are arranged in the solar cell strings.

8. The method according to claim 7, **characterized by** further comprising a step of:
detecting quality of the adhesive via a camera when applying the adhesive, and removing,
based on detection results, solar cells where the adhesive is not applied correctly.

9. The method according to claim 8, **characterized in that** the step of detecting is performed simultaneously with the step of applying the adhesive, and can provide close-loop feedback to the step of applying the adhesive.

10. The method according to claim 7, **characterized by** further comprising steps of:
arranging a entire solar cell sheet;
laser grooving the entire solar cell sheet and applying the adhesive; and
splitting the whole solar cell sheet into a plurality of solar cells.

11. The method according to claim 7, **characterized by** further comprising:
arranging a entire solar cell sheet;
laser grooving the entire solar cell sheet;
splitting the whole solar cell sheet into a plurality of solar cells; and
applying the adhesive on each of the solar cells.

12. The method according to claim 7, **characterized in that**, in a process of shingling the solar cells in solar cell strings, heat and/or pressure applied to overlapping portions between the solar cells to condense the adhesive.

13. The method according to claim 1, **characterized in that** the bottom package feature comprises a bottom panel and a bottom flexible film disposed between the bottom panel and the cell array, and the method further comprises a step of applying an adhesive on a top surface of the bottom flexible film prior to arranging the solar cells on the bottom package feature.

14. The method according to claim 13, **characterized in that** the step of applying the adhesive comprises: applying multiple groups of dot-like adhesives on the top surface of the bottom flexible film, where each group of the dot-like adhesives corresponds to one of the solar cell strings and includes one or more rows of dot-like features, and the dot-like adhesives are all arranged sequentially along the second direction and configured to engage bottom surfaces of the respective solar cells in the solar cell string.

15. The method according to claim 1, **characterized by** comprising a step of applying an adhesive after arranging the solar cells on the bottom package feature into the solar cell strings, which comprises: applying a strip adhesive on each of the solar cell strings along a second direction, to enable the strip adhesive to traverse the solar cell string.

16. The method according to claim 1, **characterized in that** the steps of arranging the solar cells into solar cell strings and arranging the solar cell strings into the cell array are implemented by electrostatic absorption or vacuum absorption.

17. The method according to claim 1, **characterized in that**, in a process of arranging the solar cells into the solar cell strings, quality of laminates are detected via a camera, and detection results are fed back to a monitoring platform in time.

18. The method according to claim 17, **characterized in that** a manufacturing system further comprises a control device which is associated with the detection mechanism and configured to control a lamination mechanism based on the detection results of the detection mechanism.

19. The method according to claim 1, **characterized in that**, prior to a lamination step, defect detection is performed on pieces to be laminated using EL or PL electroluminescence, and if detection indicates a piece to be laminated is unqualified, defect detection will be performed again after recovery of the piece.

20. The method of claim 1, **characterized by** further comprising a step of arranging the top package feature and a step of arranging the bottom package feature, wherein the step of arranging the bottom package feature comprises:
arranging a bottom panel, and
applying EVA, POE or silica gel to form a flexible film arranged between the bottom panel and the cell array; and
wherein the step of arranging the bottom package feature comprises:
applying EVA, POE or silica gel to form a flexible film arranged between a top panel and the cell array, and
arranging the top panel.

21. The method according to any of claims 1-20, **characterized in that** the adhesive is not conductive.

22. The method according to any of claims 1-20, **characterized by** not comprising a step of arranging a welding ribbon.

23. A shingled solar module, comprising a bottom package feature, a transparent top package feature, and a cell array disposed between the bottom package feature and the top package feature, the cell array comprising at least two solar cell strings arranged sequentially along a first direction, **characterized in that**,
each of the solar cell strings comprises a plurality of solar cells and a conductive sheet disposed at trailing ends of the plurality of solar cells, the plurality of solar cells and the conductive sheet being arranged in shingled manner sequentially along a second direction perpendicular to the first direction and secured relative to each other via an adhesive, wherein the respective solar cells are conductively connected through contact of main grid lines, and the conductive sheet is in contact with the main grid lines of the solar cells adjacent thereto,
wherein the shingled solar module is provided with a first busbar and a second busbar disposed together on a top or bottom side of the cell array, where the first busbar is configured to be in electrically contact with main grid lines of the solar cells at initial ends of the respective solar cell strings, the second busbar is configured to be in electric contact with the conductive sheets of the respective solar cell strings, and the each busbar is of a continuous structure and the busbars are configured to collect current from the cell array and export the current.

24. The shingled solar module according to claim 23, **characterized in that** a top surface of a solar cell at an initial end of each of the solar cell strings is provided thereon with a first conductive adhesive feature in direct contact with a main grid line of the same solar cell, a top surface of the conductive sheet is provided thereon with a second conductive feature, respective conductive adhesive features of the solar cell strings adjacent to each other are spaced apart in the first direction, the top package feature comprises a top panel, and the busbars are formed on a bottom surface of the top panel and aligned with the respective conductive adhesive features in a direction perpendicular to the cell array, enabling the busbars to come into contact with the corresponding conductive adhesive features of the solar cell strings at the same time.

25. The shingled solar module according to claim 24, **characterized in that** the top package feature further comprises a top flexible film disposed between the top panel and the cell array, and the top flexible film is provided thereon with apertures corresponding to the conductive adhesive features, conductive adhesive features electrically connect to the busbars via apertures.

26. The shingled solar module according to claim 24, **characterized in that** each section of the conductive adhesive feature is of a dot-like structure, or a strip structure extending along the first direction.

27. The shingled solar module according to claim 23, **characterized in that** the busbars are formed on the cell array, where the first busbar connects the main grid lines at the initial ends of the respective solar cell strings, and the second busbar connects the conductive sheets of the respective solar cell strings.

28. The shingled solar module according to claim 27, **characterized in that** the top package feature is not conductive.

29. The shingled solar module according to claim 23, **characterized in that** the adhesive is disposed between each pair of adjacent solar cells in each of the solar cell strings.

30. The shingled solar module according to claim 23, **characterized in that** the adhesive is arranged between each of the solar cells and the bottom package feature such that all of the solar cells are secured relative to the bottom package feature.

31. The shingled solar module according to claim 30, **characterized in that** the bottom package feature comprises a bottom panel and a bottom flexible film disposed between the bottom panel and the cell array, and the adhesive is applied onto a top surface of the bottom flexible film.

32. The shingled solar module according to claim 31, **characterized in that** the adhesive includes multiple groups of dot-like adhesives pre-arranged on the top surface of the bottom flexible film, each group of the dot-like adhesives corresponds to one of the solar cell strings, each group of the dot-like adhesives comprises one or more rows of dot-like adhesives, and the dot-like adhesives are all arranged sequentially along the second direction and configured to engage a bottom surface of each of the solar cells in the solar cell string.

33. The shingled solar module according to claim 23, **characterized in that** each of the solar cell strings is provided thereon with the adhesive of a strip structure extending along the second direction and traversing the solar cell string.

34. The shingled solar module according to claim 23, **characterized in that** the bottom package feature comprises a bottom panel and a flexible film disposed between the bottom panel and the cell array, the flexible film is of an EVA film structure, POE film structure or silica gel film structure, and the top package feature comprises a top panel and a flexible film disposed between the top panel and the cell array, the flexible film is of an EVA film structure, POE film structure or silica gel film structure.

35. The shingled solar module according to any of claims 23-34, **characterized in that** the adhesive is not conductive.

36. The shingled solar module according to any of claims 23-34, **characterized by** not comprising a welding ribbon.
